**Europäisches Patentamt**

**European Patent Office**

**Office européen des brevets**

(11) Numéro de publication: **0 027 884**
**B1**

(12) **FASCICULE DE BREVET EUROPEEN**

(45) Date de publication du fascicule du brevet: **30.05.84**

(51) Int. Cl.³: **H 03 K 3/288**

(21) Numéro de dépôt: **80105495.8**

(22) Date de dépôt: **15.09.80**

(54) **Circuit comportant au moins deux dispositifs semi-conducteurs en technologie MTL présentant des temps de montée différents et circuits logiques en dérivant.**

(30) Priorité: **30.10.79 FR 7927386**

(43) Date de publication de la demande:
**06.05.81 Bulletin 81/18**

(45) Mention de la délivrance du brevet:
**30.05.84 Bulletin 84/22**

(84) Etats contractants désignés:
**DE FR GB IT**

(56) Documents cités:
**FR-A-2 404 962**

**IEEE JOURNAL OF SOLID STATE CIRCUITS, vol. SC-13, no. 5, octobre 1978 New York US FRIEDMAN et al.: "Injection-Coupled Synchronous Logic", pages 549-555**
**IEEE TRANSACTIONS ON COMPUTERS, vol. C-26, no. 12, décembre 1977 New York US T. TICH DAO et al.: "Multivalued Integrated Injection Logic", pages 1233-1241**

(73) Titulaire: **International Business Machines Corporation**
**Old Orchard Road**
**Armonk, N.Y. 10504 (US)**

(72) Inventeur: **Lebesnerais, Gérard Maxime Albert**
**9 rue des Près**
**Saint Germain sur Ecole F-77930 Perthes (FR)**

(74) Mandataire: **Klein, Daniel Jacques Henri**
**Compagnie IBM France Département de Propriété Industrielle**
**F-06610 La Gaude (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

## Description

### Domaine technique

La présente invention concerne un circuit du type décrit dans le préambule de la revendication no. 1. Elle se rapport du domaine des circuits comportant des dispositifs semi-conducteurs en technologie MTL et plus particulièrement à un circuit de base comportant des transistors présentant des temps de montée différents et attaqués par un dispositif agissant comme un puits de courant identique pour ces transistors; suivant l'invention, la différentiation des temps de montée se fait en couplant par les régions de base l'un desdits transistors à un transistor de commande. Elle permet également les différentes applications de ce circuit de base à des circuits logiques synchrones tels que des bascules bistables de type T, des registres à décalage de type statique, etc.

### Etat de la technique

La technologie MTL (Merge Transistor Logic) encore appelée I2L (Integrated Injection Logic) est désormais bien connue dans la technique des circuits intégrés depuis quelques années. On trouvera un historique et les références bibliographiques les plus importantes dans la demande de brevet français No. 77 29867 déposée par la demanderesse le 28 septembre 1977 et publiée sous le No. FR—A— 2 404 962. Dans ce brevet on montre comment on pouvait, en faisant varier d'une façon désirée, l'espacement entre le rail d'injection et la base des différents transistors NPN, obtenir des temps de réponse différents et donner ainsi à l'injecteur un rôle de commande logique, notamment pour pré-positionner des bascules bistables dans un état logique prédéterminé à la mise sous tension.

L'état de la technique comprend également l'article intitulé: "Injection-Coupled Synchronous Logic" publié dans IEEE Journal of Solid State Circuit, Vol. SC-13, No. 5, octobre 1978, pages 549—555, par N. Friedman et al.

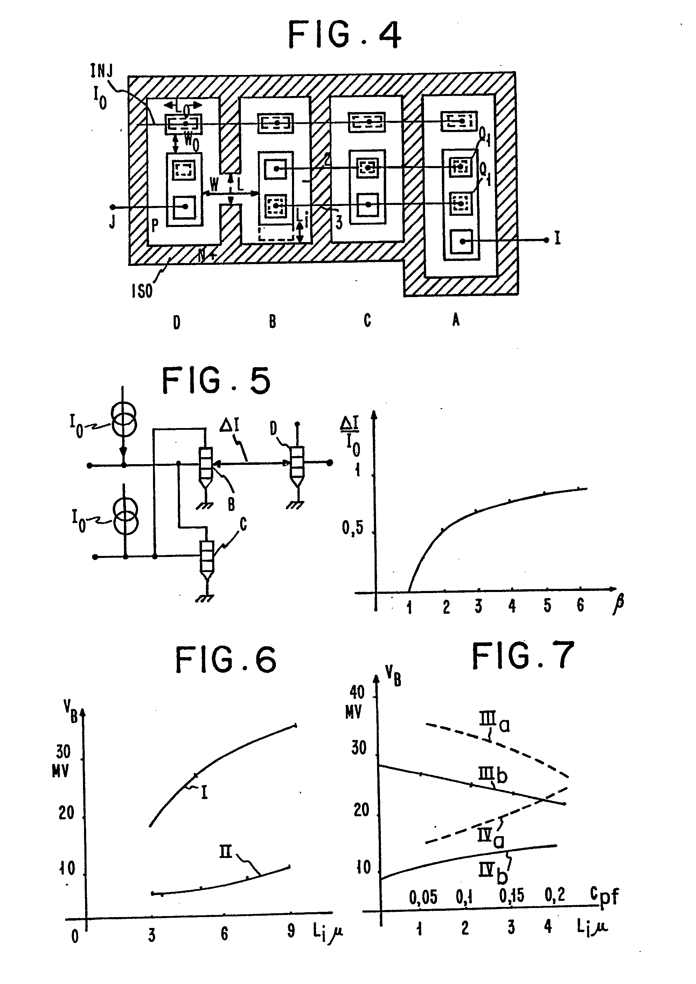

Les circuits qui sont décrits dans cette publication diffèrent sensiblement de ceux qui font l'objet de la présente demande en raison de leur comportement "pseudo-dynamique" qui indique la présence d'une impulsion d'horloge de largeur bien déterminée (voir figure 7, le générateur Cp). Il en résulte une complexité de câblage non négligeable, puisqu'il faut une région de collecteur pour commander une entrée d'horloge en technologie I2L, en particulier pour un registre à décalage, il faut autant de collecteurs en sortie du générateur Cp qu'il y aura d'étages.

### Exposé général de l'invention

La tendance actuelle de la micro-électronique est une évolution constante vers la miniaturisation des circuits. Il est en effet d'une importance capitale pour le concepteur de circuits d'augmenter la densité d'intégration des circuits sur les pastilles de silicium, soit à partir d'améliorations dans la technologie (utilisation de l'implantation ionique, de la lithographie par faisceau d'électrons,...) soit par le développement de nouveaux concepts en matière de circuits.

La technologie MTL a été déterminante dans l'augmentation de la densité des circuits bipolaires et elle est donc très largement utilisée, tant dans les circuits logiques qu'analogiques.

De façon générale la présente invention telle qu'elle est caractérisée dans la revendication no. 1 résout ce problème. Elle concerne un circuit de base en technologie MTL comportant deux transistors NPN de sortie présentant des temps de montée différents et attaqués par un transistor d'entrée leur fournissant des courants identiques. Ces temps de montée différents sont obtenus en couplant à l'un d'eux, un transistor de commande de telle sorte qu'un transistor PNP soit créé entre la base du transistor de sortie commandé et la base du transistor de commande. Une bascule bistable peut alors être obtenue si les deux transistors de sortie sont couplés en croix. Une bascule bistable de type T peut être également obtenue en couplant deux transistors NPN eux mêmes couplés en croix de cette façon avec les transistors NPN de sortie. Enfin en ajoutant un nouveau élément de mémoire intermédiaire, un registre à décalage de type statique peut être obtenu.

En permettant, comme cela sera détaillé ci-après, d'augmenter la densité de circuits, pour une fonction déterminée, outre l'intégration supplémentaire qui en résulte, on tire bénéfice en matière de vitesse de traitement et de rendements électriques.

Vis-à-vis de la référence Friedman citée ci-dessus, les circuits de la présente invention sont de type "statique" c'est-à-dire qu'ils peuvent fonctionner quelles que soient la fréquence et la durée des impulsions d'horloge. En outre, ils présentent un produit puissance xdélai excellent puisqu'ils comportent un nombre de portes élémentaires minimal, d'où une puissance dissipée réduite par rapport aux circuits connus, sans affecter par ailleurs la vitesse de commutation des portes.

D'autres aspects et avantages de la présente invention ressortiront mieux de l'exposé qui suit, fait en référence aux dessins annexés à ce texte.

### Brève description des figures

La figure 1 représente, selon l'art antérieur, deux transistors en technologie MTL montés en cascade.

La figure 2 représente, également selon l'art antérieur, deux transistors MTL attaqués par un dispositif unique en technologie MTL.

La figure 3 représente le circuit de la figure 2 auquel on a associé, conformément à l'invention, un transistor supplémentaire de couplage pour l'un des deux transistors.

La figure 4 représente la topologie du circuit de la figure 3.

La figure 5 représente le facteur de transfert en fonction du gain efficace b du transistor PNP pour le circuit de la figure 3.

La figure 6 représente les deux courbes de marge de bruit en fonction de la dimension critique L de la figure 4 pour D conducteur et bloqué.

La figure 7 représente les courbes de la marge de bruit en fonction de la capacité de la base de B, et de la longueur Li de la figure 4.

La figure 8 représente une bascule bistable de type T en technologie MTL conforme à l'invention.

La figure 9 représente un registre à décalage de type statique en technologie MTL conforme à l'invention.

La figure 10 représente la topologie du circuit de la figure 9.

Description détaillée de l'invention
I. Principe

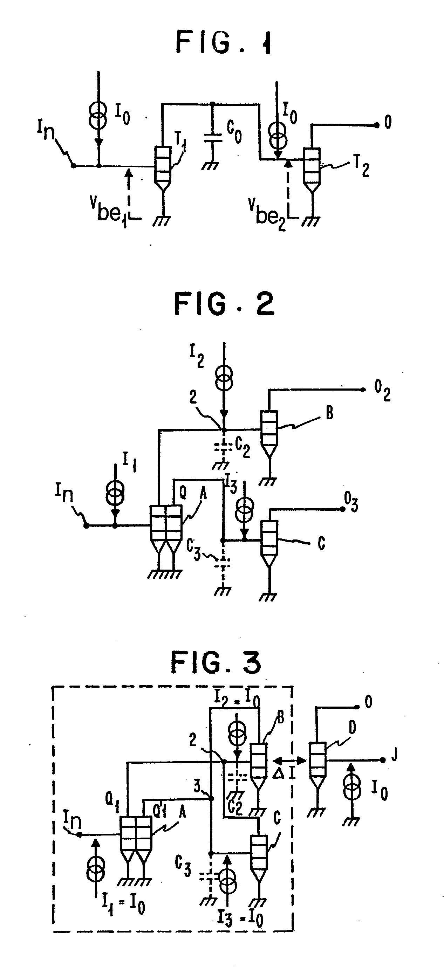

Le principe de base de la présente invention peut être compris à l'aide des figures 1 et 2, qui bien que représentatives de l'état de la technique, sont utiles pour sa compréhension.

Sur la figure 1 on a représenté, deux transistors inverseurs classiques T1 et T2 montés en cascade, réalisés selon la technologie MTL. Les bases respectives des transistors T1 et T2 sont reliées à un injecteur de courant Io. On a représenté par Co la somme des capacités parasites qui existent à ce noeud (capacités de jonctions, de diffusion, de contacts métalliques, . . .). Quand le potentiel de la base de T1 $Vbe_1$ est haut (en logique positive), le potentiel de la base de T2 $Vbe_2$ est bas, en fait égal à la tension de saturation $(V_{CE\ sat})_1$ de T1. Quand le potentiel de la base de T1 passe au niveau bas, le potentiel de la base de T2 croît avec une pente

$$\frac{dV}{dt} = \frac{Io}{Co},$$

jusqu'à atteindre sa tension maximale. Si maintenant on utilise deux transistors identiques B et C (donc C2=C3=Co) commandé par un même dispositif A (dans ce cas un transistor double avec une électrode de base unique), commandés par des sources de courant différentes I2 et I3 tels que représentées sur la figure 2, il apparaît clair que ces transistors vont présenter des pentes différentes et donc des temps de montée différents

$$\left(\frac{dV}{dt}\right)_B = \frac{I2}{Co} \quad et \quad \left(\frac{dV}{dt}\right)_C = \frac{I3}{Co}$$

c'est-à-dire que si par exemple I2>I3, le potentiel du noeud 2 augmentera plus rapidement que celui du noeud 3.

On peut noter qu'un tel résultat pourrait être également obtenu en jouant sur les valeurs des différentes capacités, en prenant donc C2≠C3 mais avec des injecteurs de courant identiques I2=I3=Io, ou encore avec des transistors B et C différents (C2≠C3 ou $Vbe_2$≠$Vbe_3$).

Il apparaît donc que si les transistors B et C sont interconnectés pour former une bascule bistable (par exemple par un couplage en croix classique), l'état de la bascule dépendra seulement des courants I2 et I3.

Pratiquement il est souhaitable pour des raisons de conception de circuits d'utiliser des transistors identiques et des sources d'injection de courant identiques, aussi la présente invention suggère de coupler un dispositif à l'un des deux transistors B ou C qui commandera effectivement le courant injecté dans ce transistor.

Sur la figure 3 on a représenté, les transistors B et C couplés en croix pour constituer une cellule de type bistable classique, en utilisant pour la simplicité de la démonstration des transistors A, B et C identiques et alimentés par la même source de courant Io. Au transistor B on a couplé, un transistor D dont le rôle sera d'ajouter au courant de base $I_{B2}$ de B un courant qui sera soit $+\Delta I$, soit $-\Delta I$, selon son état logique, lui-même commandé par le niveau appliqué à l'entrée J. En technologie MTL ce couplage entre B et D peut se réaliser au niveau de la topologie du circuit comme on va le montrer en se référant à la figure 4. Sur cette dernière qui représente la topologie du circuit de la figure 3, on reconnaît les transistors A, B et C classiques réalisés en technologie MTL avec leurs différentes interconnexions notamment les liaisons croisées entre les bases et les collecteurs des transistors B et C. Le transistor D est également représenté. Tous les transistors sont disposés dans une poche d'isolation et reçoivent le même courant d'injection (INJ). Le rail d'injection est en effet segmenté et les segments sont reliés par un conducteur commun à une source de tension Vo à travers une résistance (non représentées). Les murs d'isolation références ISO sont réalisés de façon classique par la diffusion de traversée de type $N^+$ (cette même diffusion qui assure lors de la fabrication des transistors bipolaires classiques la réalisation de la région dite de traversée qui relie la région de contact de collecteur et la région de sous-collecteur enterrée de type $N^+$ pour un transistor NPN). Le couplage est assuré entre les bases des transistors B et D, par une interruption du mur d'isolation sur une longueur L comme cela est représenté. On réalise ainsi un transistor latéral PNP, entre la base de B (du type P), la couche épitaxiale (de type N) et la base de D (de type P), qui assurera l'injection complémentaire désirée.

Le collecteur O du transistor D n'est pas strictement nécessaire au fonctionnement du circuit de la figure 3. Dans un autre mode de réalisation il peut donc être supprimé et le dispositif D de la figure 4 se réduire à l'injecteur et à la base.

Le fonctionnement du circuit peut être compris de la façon suivante: si le niveau de la base de D est bas (sur l'entrée J), D est bloqué; quand le potentiel de la base de B passe à un niveau haut, un courant de trous (ΔI) va circuler de la base de B vers la base de D, qui constitue le collecteur du transistor latéral PNP défini plus haut, ainsi la capacité C2 ramenée sur la base de B va être chargée avec une pente

$$\frac{Io-\Delta I}{C2},$$

cette pente définit le temps de montée du transistor B. Alors qu'un courant Io charge la capacité C3 associée au transistor C. Aussi d'après ce qui a été dit plus haut (figures 1 et 2), à la fin de la charge, B sera bloqué et par conséquent C sera conducteur.

Inversement si le niveau de la base de D est haut, le courant de trous du transistor PNP va circuler de la base de D vers la base de B; le courant qui va charge la capacité C2 sera cette fois Io+ΔI, supérieur au courant de charge de la capacité C3 du transistor C, par conséquent ce dernier est bloqué, tandis que le transistor B est rendu conducteur.

En ce qui concerne l'efficacité de ce type de couplage en matière d'immunité au bruit on doit comprendre que cette dernière est meilleure quand D est conducteur que lorsqu'il est bloqué, simplement parce qu'au début du processus de charge des capacités C2 et C3, la différence entre les courants de base $I_{B2}$ et $I_{B3}$ de B et de C respectivement est plus importante quand D est conducteur. D injecte des trous dans la base de B dès que le potentiel de la base de B augmente. Par contre quand D est bloqué, B injecte des trous dans la base de D seulement quand le potentiel de la base de B est suffisamment élevé, (c'est-à-dire à environ 0,6 V), c'est alors que le courant injecté est significatif ou plus exactement que la différence entre $I_{B2}$ et $I_{B3}$ est plus significative.

En d'autres termes, si les transistors B et C ne sont pas rigoureusement identiques, l'immunité au bruit du circuit de la figure 3 peut être médiocre. Il est cependant possible d'avoir une immunité identique pour B et C, si par une topologie appropriée on assure des temps de montée différents pour B et C, par exemple pour rendre C plus rapide que B, l'immunité au bruit de B augmentera quand D est bloqué mais diminuera quand il sera conducteur (ce qui n'est pas gênant en raison de la sécurité qui existe dans ce cas). La simulation a monté qu'une capacité supplémentaire de 0,2 pf sur la base de B suffirait. Ceci peut être obtenu de plusieurs façons: rendre la base de B plus longue que celle de C (paramètre Li), on peut également jouer sur la topologie de l'injection (en réduisant la largeur de la base de B), on pourrait encore penser à utiliser deux PNP latéraux pour ajuster séparément l'immunité au bruit de B et C.

L'immunité au bruit de deux dispositifs se mesure à l'aide de la marge de bruit ou différence entre les tensions de seuil de fonctionnement des deux dispositifs. Plus grande est la marge, plus grande est l'immunité au bruit. Sur la figure 6 on a représenté la marge de bruit $V_B$ en mV en fonction de Li pour les cas où le transistor D est conducteur (courbe I) et où il est bloqué (courbe II). La sensibilité de la marge de bruit en fonction de là capacité est montrée sur la figure 7 pour ces deux cas (courbes IIIa et IVa). La sensibilité de la marge de bruit en fonction de Li est montrée également sur la figure 7 (courbes IIIb et IVb).

Un autre problème est celui de l'évaluation de la stabilité. La condition est ici que le courant de couplage qui s'ajoute au courant d'injection ne modifie pas le fonctionnement (l'état) de la bascule quand il se produit seul. En d'autres termes le couplage doit être suffisant pour différencier le fonctionnement des transistors B et C, sans pour autant modifier l'état de la bascule à lui seul, afin que la bascule n'entre pas en oscillations. L'effet transistor du PNP ne doit pas être trop efficace. Sur la figure 4 on a représenté le schéma simplifié (topologie) du circuit de la figure 3; si $\beta$ est le gain efficace du transistor D qui sera défini plus loin, il y aura stabilité si on a la relation

$$(Io-\Delta I)\ \beta > Io \text{ (courant d'injection)}$$

$$\text{soit}\quad \frac{\Delta I}{Io} < \frac{\beta-1}{\beta}\quad \text{où}\quad \frac{\Delta I}{Io}$$

est le rapport de transfert qui est montré en fonction de $\beta$ sur la courbe de la figure 5.

Le gain efficace $\beta$ est défini comme le rapport entre le courant collecteur et le courant injecté dans la base de l'injecteur.

ΔI est proportionnel à L, tandis que Io est proportionnel à Lo (largeur du rail d'injection). On peut donc effectivement jouer sur ces deux paramètres pour assurer la stabilité du système.

Si W est la distance entre les bases des dispositifs B et D, ΔI est proportionnel à L/W. De la même façon Io est proportionnel à Lo/Wo si Wo est la distance entre l'injecteur et la base du dispositif D.

On a alors

$$\frac{\Delta I}{Io} = \frac{L \times Wo}{W \times Lo}$$

La condition

$$\frac{\Delta I}{Io} < \frac{\beta-1}{\beta}$$

peut donc se transformer en

$$L < \frac{W \times Lo}{Wo} \cdot \frac{\beta - 1}{\beta}.$$

## II. Généralisation

De très nombreux circuits logiques synchrones peuvent mettre en oeuvre les principes de la présente invention. On donnera ci-après deux exemples de réalisation, l'un appliqué aux bascules bistables de type T, et l'autre à un registre à décalage de type statique.

### (I) Bascule bistable de type T

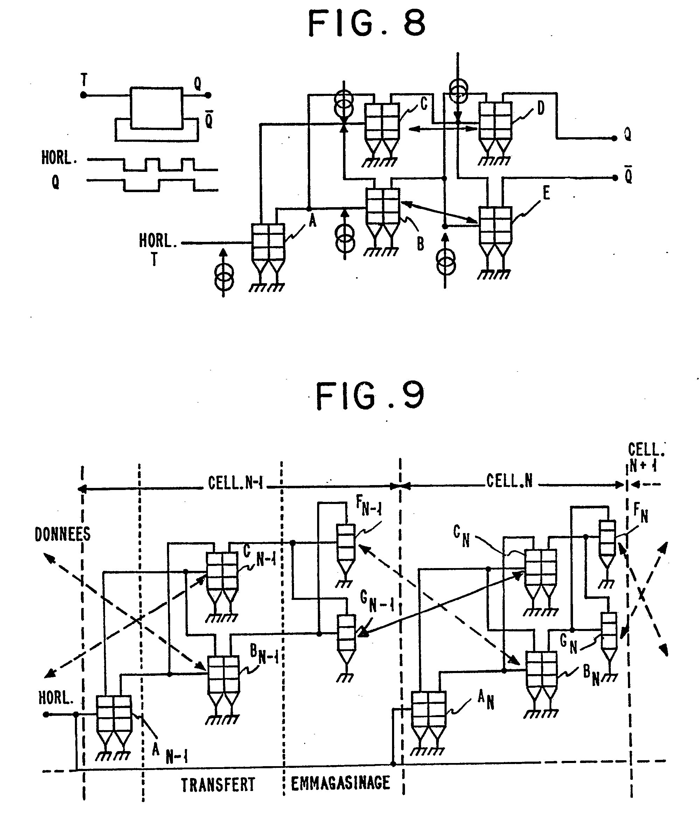

Ce type de bascule est très largement utilisé notamment dans les compteurs, diviseurs par deux, ..., cette bascule est obtenue simplement en reliant l'entrée des données d'une bascule bistable Eccles-Jordan à la sortie complémentée ($\overline{Q}$). La bascule de type T change d'état à chaque impulsion d'horloge reçue sur l'entrée T. La figure 8 montre cette bascule en technologie MTL, réalisée avec cinq dispositifs MTL A, B, C, D et E à double collecteurs (comme A sur la figure 4). La liaison entrée des données avec la sortie ($\overline{Q}$) est réalisée par le couplage entre B et E. Au moins une paire de dispositifs est couplée conformément aux enseignements de la présente invention C et D ou B et E. Mais on peut réaliser le couplage des deux paires de dispositifs si on veut assurer une bonne immunité au bruit dans les deux cas étudiés plus haut (transistor D: conducteur ou bloqué). Le fonctionnement est le suivant:

Supposons que l'élément bistable composé des transistors D et E soit tel que Q=1, pour le niveau haut du signal d'horloge, cela signifie que D est bloqué, E est conducteur (B et C étant alors bloqués par le transistor A). Quand le signal d'horloge devient bas, A se bloque, le potentiel des bases de B et C augmente, le transistor E qui est conducteur envoie sur le transistor B, le courant de couplage $\Delta I$, le transistor B devient plus rapidement conducteur que C (qui est couplé à D bloqué). La bascule va changer d'état, B et D deviennent conducteurs, C et E se bloquent et Q=0. Quand l'impulsion suivante de l'horloge remonte au potentiel haut, A est saturé, les transistors B et C se bloquent, et il n'y a aucune interaction avec les transistors D et E; l'élément de bascule composé des transistors D et E demeure dans l'état logique précédent. La bascule fonctionne donc comme un diviseur par deux.

Dans ce cas comparé à une réalisation classique, telle que l'on peut la trouver dans la littérature: notamment dans l'article de Richard L. Horton, intitulé: "I2L Takes Bipolar Integration a Significant Step Forward" et publié dans la revue: Electronics, février 6, 1975, page 83, le nombre de dispositifs est de cinq (au lieu de sept en tenant compte du dispositif d'entrée qui n'est pas représenté) et le nombre de collecteurs de dix au lieu de quinze.

La présente invention permet donc une augmentation sensible de la densité d'intégration.

### (II) Registre à décalage de type statique

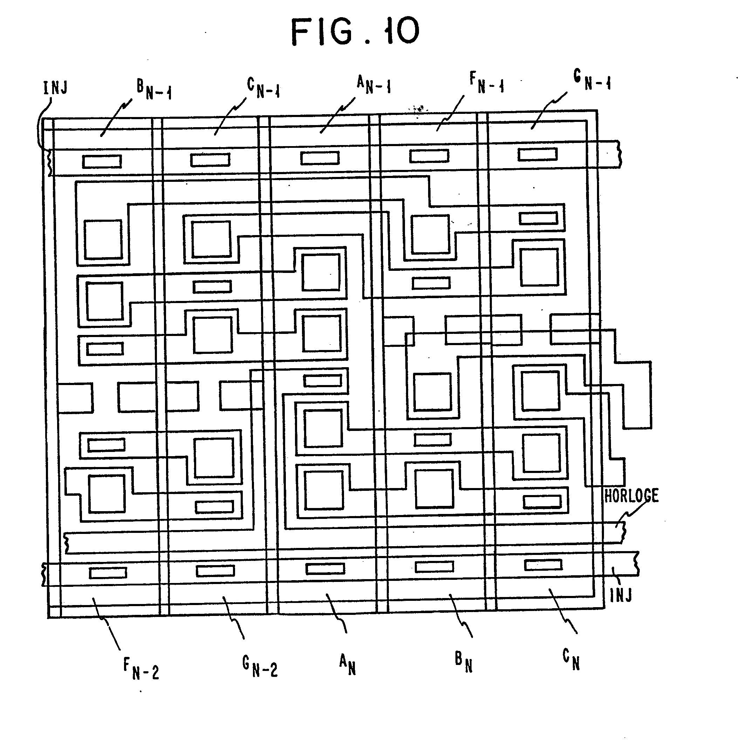

Deux cellules successives $CELL_{N-1}$ et $CELL_N$ d'un tel registre sont représentées sur la figure 9. La première cellule comporte un dispositif d'entrée $A_{N-1}$ qui attaque un élément bistable composé des dispositifs $B_{N-1}$ et $C_{N-1}$. Le dispositif $C_{N-1}$ reçoit également les données à faire circuler sur sa base; les dispositifs $B_{N-1}$ et $C_{N-1}$ qui constituent la partie transfert de la cellule $CELL_{N-1}$ sont associés à l'élément bistable composé par les dispositifs $F_{N-1}$ et $G_{N-1}$ qui en constituent la partie emmagasinage. La cellule $CELL_N$ est identique dans sa constitution à la cellule $CELL_{N-1}$. L'horloge attaque les dispositifs $A_{N-1}$, $A_N$, .... Les cellules $CELL_{N-1}$ et $CELL_N$ sont couplées conformément aux enseignements de la présente invention comme montré sur la figure 9. On peut se satisfaire d'un seul couplage (dispositif $G_{N-1}$ et $C_N$) ou de deux couplages: en couplant également $F_{N-1}$ et $B_N$. La figure 10 qui représente partiellement la topologie de ces cellules, montre bien que les dispositifs $F_{N-1}$ et $B_N$ d'une part et $G_{N-1}$ et $C_N$ d'autre part sont adjacents pour permettre le couplage entre les bases grâce à des interruptions dans le mur d'isolation (sur une largeur de 5 à 12 $\mu$m). C'est ainsi que la donnée qui a été transférée au dispositif $F_{N-1}$ à la première impulsion d'horloge est transférée dans le dispositif $F_N$ à la seconde impulsion d'horloge.

En effet quand le signal d'horloge est haut (fonction emmagasinage), $A_{N-1}$ est saturé, les dispositifs $B_{N-1}$ et $C_{N-1}$ sont bloqués, $F_{N-1}$ est conducteur tandis que $G_{N-1}$ est bloqué. La base de $F_{N-1}$ est donc à potentiel haut quand le signal d'horloge est au niveau bas (fonction transfert). On vient forcer la base de $A_N$ au niveau bas, le potentiel croît sur les deux bases des dispositifs $C_N$ et $B_N$, mais $F_{N-1}$ injecte des trous vers $B_N$, ce dernier reçoit plus de courant que $C_N$ ainsi $C_N$ sera bloqué pendant que $B_N$ est rendu conducteur, le collecteur de $B_N$ voit son potentiel décroître, donc $G_N$ se bloque, tandis que $F_N$ conduit. On a bien transporté l'information de $F_{N-1}$ à $F_N$. Le couplage entre l'entrée de données et le dispositif C1 de la cellule $CELL_1$ peut être réalisé également par un PNP latéral conformément à la présente invention (non représenté). On prendra la précaution que le couplage entre les dispositifs $F_{N-1}$ et $C_N$ soit suffisamment faible pour que l'état des bascules ne change pas (effet d'oscillation qui comme on l'a vu ci-dessus, doit être évité pour la stabilité du circuit).

On remarquera que deux dispositifs successifs qui reçoivent les impulsions d'horloge, par exemple $A_{N-1}$ et $A_N$, sont intégrés en un dispositif unique muni de deux injecteurs et de quatre collecteurs comme cela apparaît sur la figure 10. On remarquera également que $G_{N-1}$ et $C_N$ d'une part $F_{N-1}$ et $B_N$ sont disposés très voisins sur le substrat silicium on peut donc être assuré qu'ils présenteront des caractéristiques identiques et donc une bonne immunité au bruit. Vis-à-vis d'un registre à décalage conventionnel en technologie MTL qui nécessite environ sept dispositifs et treize collecteurs, l'approche proposée ne demande que cinq dispositifs et huit collecteurs. Le gain en surface est d'environ 30%, cette topologie a permis d'obtenir jusqu'à 100 bits/mm² au lieu de 75 bits/mm². Par ailleurs, la vitesse étant directement fonction de la dimension de la base du dispositif (charge des trous entre la diffusion base et le sous-collecteur), une amélioration de la vitesse d'environ 20% est possible. Enfin, les fuites émetteur-collecteur qui constituent le défaut majeur de la technologie MTL et qui influencent défavorablement les rendements de fabrication, sont ici réduites en raison de la diminution du nombre de collecteurs.

Ainsi en partant d'une cellule bistable de base, telle que celle qui a été représentée sur les figures 2 et 4, composée de deux transistors (B et C) couplés en croix, sauf différentiation volontaire des transistors B et C, l'état final de cette bascule est indéterminée. A cette cellule on a associé un transistor de commande (D) qui assure un couplage par un effet transistor PNP entre sa base et la base d'un des deux transistors (B) de la cellule. L'état du bistable dépend cette fois de l'état du transistor de commande, et donc de l'entrée logique J. En technologie MTL de couplage s'effectue par une interruption du mur d'isolation entre les dispositifs B et D.

Dans une première variante, à partir de cette même cellule de base (composée des transistors A, B et C) on a associé deux dispositifs (D et E) couplés en croix attaqués par la sortie des dispositifs C et B et en outre couplés par les bases C et D d'une part B et E d'autre part. Un tel circuit constitue une bascule bistable de type T, dont le dispositif d'entrée A reçoit le signal d'horloge.

Si cette fois on considère la cellule de base munie d'une entrée logique sur la base d'un des deux dispositifs (C1) de la première cellule (non représentée) et que les dispositifs d'entrée ($A_{N-1}$) sont attaqués par le signal d'horloge; cette cellule constitue la partie transfert d'une cellule de registre à décalage dont la partie emmagasinage est composée par deux dispositifs couplés en croix ($F_{N-1}$ et $G_{N-1}$) qui sont attaqués respectivement par les dispositifs ($C_{N-1}$ et $B_{N-1}$. Le registre à décalage est obtenu en couplant en croix les dispositifs d'entrée $B_N$ et $C_N$ de la cellule N, aux dispositifs de la partie emmagasinage $F_{N-1}$ et $G_{N-1}$ respectivement.

D'autres extensions sont possibles à partir de la cellule de base.

### Revendications

1. Circuit comportant des dispositifs semiconducteurs en technologie MTL comportant un dispositif d'entrée (A) agissant de la même façon comme puits de courant sur au moins deux dispositifs de sortie (B, C), caractérisé en ce qu'il comporte au moins un dispositif de commande (D) contrôlé par une entrée logique (I) couplé à l'un (B) des dispositifs de sortie, appelé dispositif commandé, de telle sorte qu'il assure par effet transistor des temps de montée différents auxdits dispositifs de sortie.

2. Circuit selon la revendication 1 caractérisé en ce que les dispositifs de sortie (B, C) et d'entrée (A) d'une part et de commande (D) d'autre part sont respectivement constitués par des transistors NPN à collecteur unique pour les dispositifs de sortie, à collecteur double pour le dispositif d'entrée et en ce que les dispositifs de sortie sont couplés en croix pour former un élément de mémoire, l'ensemble des dispositifs d'entrée et de sortie constituant une cellule de transfert.

3. Circuit selon la revendication 2 caractérisé en ce que les transistors de sortie (B, C) sont pratiquement identiques et reçoivent des courants d'injection (lo) pratiquement identiques.

4. Circuit selon la revendication 1 caractérisé en ce que les dispositif d'entrée (A) et de sortie (B, C) forment une cellule de transfert et sont constitués par des transistors NPN à collecteur double pratiquement identiques et reçoivent des courant d'injection (lo) pratiquement identiques.

5. Circuit selon la revendication 4 caractérisé en ce que aux dispositifs de sortie (B, C) on couple deux dispositifs supplémentaires (D, E) constitués par deux transistors NPN à collecteur double eux mêmes couplés en croix pour constituer un élément de mémoire, dispositif à dispositif, (C avec D et B avec E) et en ce que l'on applique le signal d'horloge sur la base du dispositif d'entrée pour obtenir une bascule bistable de type T dont les sorties Q et $\bar{Q}$ sont disponibles sur les collecteurs non utilisés desdits dispositifs supplémentaires.

6. Circuit selon la revendication 4 caractérisé en ce que l'on associe à cette cellule de transfert, une cellule d'emmagasinage (F, G) composée de deux dispositifs identiques constitués par deux transistors simples NPN, eux mêmes couplés en croix pour constituer une cellule d'un registre à décalage, en outre au moins un dispositif de cette cellule (F) est couplé par effet transistor avec un dispositif de sortie (B) de la cellule suivante identique, pour constituer un registre à décalage dont tous les dispositifs d'entrée sont attaqués par le même signal d'horloge.

7. Circuit selon l'une des revendications 2 à 6 caractérisé en ce que ledit couplage par effet transistor est assuré par un transistor PNP créé entre la base du transistor de sortie commandé et la base du transistor de commande.

8. Circuit selon la revendication 7 caractérisé en ce que le couplage est réalisée par une ouverture pratiquée dans le mur d'isolation sur une longueur déterminée L entre le transistor commandé et le transistor de commande, disposés adjacents.

9. Circuit selon la revendication 8 caractérisé en ce que le couplage est ajusté soit par la longueur de l'ouverture L, soit par la longueur de la base du transistor commandé.

**Patentansprüche**

1. Schaltungsanordnung mit Halbleitervorrichtungen in MLT-Technologie mit einer Eingangsanordnung (A), die auch als Stromsenke fuer mindestens zwei Ausgangsanordnungen (B, C) wirkt, dadurch gekennzeichnet, dass sie mindestens eine Steueranordnung (D) aufweist, die von einer logischen an einer als angesteuerten Anordnung bezeichneten Ausgangsanordnung (B) aus den zwei Ausgangsanordnungen gekoppelten Eingabe (I) gesteuert ist, so dass die Steueranordnung den Ausgangsanordnung wegen des Transistoreffekts verschiedene Anstiegszeiten zuweist.

2. Schaltungsanordnung nach Anspruch 1, dadurch gekennzeichnet, dass die Ausgangsanordnungen (B, C) und die Eingangsanordnung (A) einerseits und die Steueranordnung (C) andererseits jeweils aus NPN-Transistoren mit einem einzigen Kollektor fuer die jeweiligen Ausgangsanordnungen und mit einem Doppelkollektor fuer die jeweilige Eingangsanordnung bestehen, und die Ausgangsanordnungen zur Bildung eines Speicherelements kreuzgekoppelt sind, wobei die gesamten Eingangs- und Ausgangsanordnungen eine Uebertragungszelle bilden.

3. Schaltungsanordnung nach Anspruch 2, dadurch gekennzeichnet, dass die Ausgangstransistoren (B, C) sozusagen aenhlich und von sozusagen aehnlichen Injektionsstroemen (Io) gespeist sind.

4. Schaltungsanordnung nach Anspruch 1, dadurch gekennzeichnet, dass die Eingangsanordnung (A) und die Ausgangsanordnungen (B, C) eine Uebertragungszelle bilden, aus sozusagen aehnlichen NPN-Transistoren mit einem Doppelkollektor bestehen und schliesslich von aehnlichen Injektionsstroemen (Io) gespeist sind.

5. Schaltungsanordnung nach Anspruch 4, dadurch gekennzeichnet, dass die Ausgangsanordnungen (B, C) an zwei zusaetzlichen Anordnungen (D, E) gekoppelt sind, die aus zwei ihrerseits zur Bildung eines Speicherelements kreuzgekoppelten NPN-Transistoren mit einem Doppelkollektor bestehen, wobei jede Ausgangsanordnung jeweils an einer zusaetzlichen Anordnung (C an D und B an E) gekoppelt ist, und dass ein Taktsignal der Basis der Eingangsanordnung zugefuehrt ist, um eine bistabile T-Kippschaltung zu bilden, deren Ausgaenge Q et Q̄ den freistehenden Kollektoren der zusaetzlichen Anordnungen entnehmbar sind.

6. Schaltungsanordnung nach Anspruch 4, dadurch gekennzeichnet, dass dieser Uebertragungszelle eine Speicherzelle (F, G) zugeordnet ist, die zwei aehnliche Anordnungen einschliesst, die aus zwei einfachen ihrerseits zur Bildung einer Verschiebungsregister-Zelle kreuzgekoppelten NPN-Transistoren bestehen, ausserdem mindestens eine Anordnung dieser Zelle (F) durch den Transistoreffekt an einer Ausgangsanordnung (B) der nachfolgenden aehnlichen Zelle zur Bildung eines Verschiebungsregisters gekoppelt ist, deren Eingangsanordnungen von dem gleichen Taktsignal getrieben sind.

7. Schaltungsanordnung nach einem der Ansprueche 2 bis 6, dadurch gekennzeichnet, dass die durch den Transistoreffekt durchgefuehrte Kopplung von einem zwischen der Basis des angesteuerten Ausgangstransistors und der Basis des Steuertransistors hergestellten PNP-Transistor geschaffen ist.

8. Schaltungsanordnung nach Anspruch 7, dadurch gekennzeichnet, dass die Kopplung durch eine in dem Isolierungsmauer angeordnete Oeffnung auf eine vorbestimmte L-Laenge zwischen dem angesteuerten Transistor und dem Steuertransistor, die beieinanderliegen, durchgefuehrt ist.

9. Schaltungsanordnung nach Anspruch 8, dadurch gekennzeichnet, dass die Kopplung entweder durch die L-Laenge der Oeffnung oder durch die Laenge der Basis des angesteuerten Transistors eingestellt ist.

**Claims**

1. Circuit comprising semiconductor devices in MTL technology provided with an input device (A) acting in the same manner as a current sink on at least two output devices (B, C), characterized in that it includes at least one control device (D) controlled by a logic input (I) coupled to one (B) of the output devices, the so-called controlled device, so that, upon transistor effect it provides different rise times to said output devices.

2. A circuit according to claim 1, characterized in that the output devices (B, C) and the input device (A), on the one hand, and the control device (D), on the other hand, are respectively formed of single collector NPN transistors for the output devices, of dual collector for the input device, and in that the output devices are cross-coupled in order to form a memory element, the input and output device assembly forming a transfer cell.

3. A circuit according to claim 2, characterized in that the output transistors (B, C) are substantially identical and receive substantially identical injection currents (Io).

4. A circuit according to claim 1, characterized in that the input device (A) and the output devices (B, C) form a transfer cell and are comprised of substantially identical dual collector NPN transistors and receive substantially identical injection currents (Io).

5. A circuit according to claim 4, characterized in that two additional devices (D, E) are coupled to the output devices (B, C) and are comprised of two dual collector NPN transistors which are themselves cross-coupled to form a memory element (C coupled with D, and B coupled with E), and in that the clock signal is applied to the base of the input device to achieve a T-type flip-flop the outputs Q and $\overline{Q}$ of which are available on the collectors not in use in said additional devices.

6. A circuit according to claim 4, characterized in that a storing cell (F, G) is associated with said transfer cell and is formed of two identical devices comprised of two single NPN transistors which are themselves cross-coupled to form a shift register cell, and in that at least one device of said cell (F) is transistor effect-coupled to an output device (B) of the next identical cell to form a shift register all the input devices of which are driven by the same clock signal.

7. A circuit according to claims 2 through 6, characterized in that said transistor effect coupling is ensured by a PNP transistor created between the base of the controlled output transistors and the base of the control transistor.

8. A circuit according to claim 7, characterized in that coupling is achieved by means of an opening of a determined length L made in the isolation wall between the adjacent controlled and control transistors.

9. A circuit according to claim 8, characterized in that coupling is adjusted either by length L of the opening or by the length of the controlled device base.

FIG. 1

FIG. 2

FIG. 3

# FIG . 4

# FIG . 5

# FIG . 6

# FIG . 7

# FIG. 8

# FIG. 9

# FIG . 10